# EUROPÄISCHE PATENTSCHRIFT

(11) **EP 0 234 294 B1**
(45) Veröffentlichungstag und Bekanntmachung des Hinweises auf die Patenterteilung: **28.04.1993**
(21) Anmeldenummer: 87100958.5
(22) Anmeldetag: 23.01.1987
(51) Int. Cl.: H05K 5/04, H05K 7/18

(54) **Computergehäuse**
Computer casing
Coffret d'ordinateur

(30) Priorität: 23.01.1986 DE 8601620 U
(43) Veröffentlichungstag der Anmeldung: 02.09.1987
(73) Patentinhaber: Tappert, Karl-Heinz, D-40764 Langenfeld (DE)
(72) Erfinder: Tappert, Karl-Heinz, D-4018 Langenfeld (DE); Salich, Erich, D-5650 Solingen (DE)
(74) Vertreter: Stratmann, Ernst, Dr.-Ing.

(56) Entgegenhaltungen:
- DE-U- 8 335 383
- US-A- 4 484 692
- US-A- 4 598 964

## Beschreibung

Die Erfindung betrifft ein Computergehäuse, bestehend aus einem Rahmenteil zur Aufnahme von Einschüben, Baugruppenträgern, Laufwerken, Netzteilen, Lüftern, Bedienungsfrontplatte und dgl. und/oder bereits in einem Gehäuse befindlichen Computern, und am Rahmenteil befestigbaren Gehäusewandteilen sowie einem Abdeckhaubenteil.

Ein derartiges Computergehäuse ist bekannt aus einem Prospekt der Firma TRIMMINDUSTRIES, North Hollywood, California, USA, mit der Bezeichnung "The TRIMM Tower".

Derartige Computergehäuse dienen beispielsweise zur Aufnahme der Hardware von Bürocomputereinrichtungen, zu welchem Zweck sich derartige Computergehäuse unter Schreibtischplatten schieben lassen oder die gleiche Höhe wie diese aufweisen.

Die Computergehäuse befinden sich also in einem Bereich, der auch für Personen zugänglich ist, die diesen Einrichtungen nicht direkt zugeordnet sind. Damit besteht die Gefahr, daß Personen Zugang zu diesen Einrichtungen bekommen, die entweder aus Gründen der Unkenntnis oder auch des Mißbrauchs die in dem Computergehäuse untergebrachten Einrichtungen beschädigen oder verstellen.

Bei dem bekannten Computergehäuse, bei dem die Seitenwände und Deckelteil (Abdeckhaube) mit Hilfe von Schnappverschlüssen an dem Rahmengestell befestigt sind, besteht somit die Gefahr, daß derartige unautorisierte Personen ohne größere Schwierigkeiten durch Abnehmen der Seitenwände und/oder des Deckelteils Zugang zu den inneren Einrichtungen erhalten und nicht gewünschte Manipulationen an dem Computer vornehmen können. Auch besteht die Gefahr, daß spannungsführende Teile berührt werden können sowie empfindliche Daten, die in dem Computergehäuse zugänglich sein mögen, in die Hände von unautorisierten Personen gelangen.

Es ist daher erstrebenswert, diese Zugangsmöglichkeit zu dem Inneren des Computergehäuses möglichst weitgehend zu erschweren.

Aufgabe der Erfindung ist es, das Computergehäuse der eingangs genannten Art dahingehend zu verbessern, daß nur noch mit Hilfe von besonderen Einrichtungen, wie Schlüssel, Spezialwerkzeug o. dgl. die Verkleidungsteile des Gehäuses, nämlich die Gehäusewandteile (Seitenwände, ggf. Vorder- und Hinterwand) sowie ggf. ein Fuß oder die Abdeckhaube entfernt werden können, oder daß zumindest sofort erkennbar wird, daß eine unautorisierte Öffnung des Computergehäuses stattgefunden hat.

Gelöst wird diese Aufgabe dadurch, daß Gehäusewandteile und Abdeckhaubenteil ihre eigenen Befestigungseinrichtungen und/oder die Befestigungseinrichtungen angrenzender, vorher befestigter Wand- oder Haubenteile derart abdecken, daß nur das letzte in der Montageaufeinanderfolge montierte Teil mittels einer zugänglichen Befestigungseinrichtung, die eine gegen unbefugtes Lösen sicherbare Verriegelung oder Verplombung umfaßt, arretierbar ist.

Durch diese Maßnahmen wird es unautorisierten Personen erschwert, überhaupt das Computergehäuse zu öffnen, oder aber eine derartige Öffnung ist infolge Verplombungsbeschädigung sofort sichtbar.

Unautorisierte Eingriffe sowie Datenmißbrauch können daher entweder ganz verhindert werden, oder aber die Folgeschäden davon können verkleinert werden.

Dem Computergehäuse kann ein Fußteil zugeordnet sein, auf dem das Rahmenteil befestigt ist. In diesem Fall kann ein Rahmenteil ohne (geschlossenes) Bodenblech verwendet werden. Falls ein Fußteil vorhanden ist, können die Gehäusewandteile auch ggf. an diesem befestigt werden.

Es hat sich als besonders günstig erwiesen, wenn die Befestigungseinrichtungen von den Wand- bzw. Haubenteilen vorspringende Laschen umfassen, die in Durchbrüchen entsprechend ausgerichteter Laschen eines angrenzenden Teils (sei es ein Wandteil, ein Fußteil oder ein Haubenteil) einschiebbar sind oder einen Durchbruch aufweisen, der zu einem Durchbruch des angrenzenden Teils und/oder des Fuß- oder Rahmenteils derart fluchtet, daß ein beide Durchbrüche durchgreifendes Befestigungsmittel, wie Schraube, Stift, weitere Lasche, Zunge eines Verschlusses o. dgl. die Teile zueinander sichert.

Die sicherbare Verriegelung kann dabei insbesondere ein abschließbarer Vorreiberverschluß sein oder diesen umfassen. Eine andere Möglichkeit wäre die, die sicherbare Verriegelung mit Hilfe einer Spezialschraube zu verwirklichen oder eine Plombierung vorzusehen.

Gemäß einer noch anderen Weiterbildung der Erfindung tragen die Längsseitenwände innen am unteren Ende nach unten offene L-Laschen, die in entsprechende nach oben offene L-Laschen oder Durchbrüche des Rahmen- oder Fußteils von oben einschiebbar sind, wobei die Längsseitenwände oder das Rahmenteil am oberen Ende zumindest eine von der Wandebene nach innen vorspringende weitere Lasche tragen, die einen Durchbruch für ein stiftartiges Befestigungsmittel besitzt.

Dieses stiftartige Befestigungsmittel kann eine Blechschraube, Gewindeschraube, ein Spreizniet o. dgl. sein, es könnte sich aber auch um andere Verstiftungen handeln, beispielsweise Splinte, gebogene und dadurch nach unten sich ausrichtende, mit Kopf versehene Stifte und ähnliches.

Die Vorder- und/oder Hinterwand kann gemäß einer noch anderen Ausbildung der Erfindung am unteren Ende nach innen/unten abgewinkelte Wandbereiche besitzen, die in entsprechende Durchbrüche einschiebbar oder hinter entsprechende Querleisten am Fuß- oder Rahmenteil einhängbar sind, und die Hinterwand (oder auch Vorderwand) könnte am oberen Ende in einen in dem Bereich der Haube hineinragenden Wandbereich auslaufen, der einen Querschlitz zur Aufnahme einer horizontalen Lasche oder Abwinkelung aufweist, die am zugehörigen unteren Randende der Haube angebracht ist oder durch Abwinkelung des Randendes entstanden ist.

Die Haube kann am gegenüberliegenden Ende nach unten vorspringende Laschen oder eine Abwinkelung aufweisen, die mit Durchbrüchen für ein stiftartiges Befestigungsmittel versehen sind.

Insbesondere können die Durchbrüche für das stiftartige Befestigungsmittel zu den entsprechenden Durchbrüchen der Seitenwände bzw. des Rahmenteils fluchten und gemeinsam von dem stiftartigen Befestigungsmittel durchdrungen sein. Dies vereinfacht sehr die Montage der einzelnen Gehäuseteile und verringert die Anzahl der benötigten Stifte.

Die Hinterwand (alternativ auch die Vorderwand bzw. Rahmenteil) können an ihrem oberen Ende einen abschließbaren Vorreiberverschluß aufweisen, dessen Zunge in einen Schlitz oder hinter eine Strebe oder Abwinkelung der Haube greift.

Die Seitenwände können am oberen Ende einen Ansatz aufweisen, an den sich der nach unten gezogene Rand der Haube zur Sicherung der Seitenwand anlegt. Dieser Ansatz könnte gegenüber der Außenebene der Seitenwand auch zurückspringen. Besonders günstig ist es dann, wenn der Rand der Haube eine nach innen weisende Umbördelung aufweist bzw. ein U-Profil bildet, dessen freie Stirnkante die Anlage für den Ansatz der Seitenwand darstellt.

Zur Montagevereinfachung kann es vorteilhaft sein, das Computergehäuse mit z. B. nur drei Seitenwänden auszustatten, wobei die vierte Wand dann vom Gehäuse des Computers gebildet wird. Insbesondere bei Unterbringung von bereits mit Gehäuse ausgestatteten Computern, deren Gehäuse aber nicht gegen unbefugte Eingriffe schützt, kannes günstig sein, wenn gemäß einer noch anderen Ausführungsform zwei, insbesondere sich gegenüberliegende Gehäusewandteile mit einem Bodenteil fest verbunden, z. B. verschraubt, vernietet, verschweißt, verklebt oder einstückig gebogen sind und das Rahmenteil bilden.

Die sicherbare Verriegelungseinrichtung kann im Rahmenteil angeordnet sein - beispielsweise in einem Bodenteil oder in einem der beiden Gehäusewandteile, wenn diese einen Teil des Rahmenteils bilden - oder aber in einem der am Rahmenteil befestigbaren Gehäusewandteile oder - wegen guter Zugänglichkeit besonders günstig - im Abdeckhaubenteil angeordnet sein.

Das Gehäuse wird üblicherweise aus Metallblech, insbesondere Stahlblech oder Aluminiumblech hergestellt sein, jedoch sind auch Kunststoffplatten, insbesondere solche mit Glasfaserverstärkung einsetzbar.

Die Erfindung wird nachfolgend anhand von Ausführungsbeispielen näher erläutert, die in den Zeichnungen dargestellt sind.

Es zeigt:
- Fig. 1: in einer auseinandergezogenen Darstellung die wesentlichen Einzelteile eines Computergehäuses, bei dem die erfindungsgemäßen Merkmale mit Vorteil eingesetzt werden können;
- Fig. 2: ein Computergehäuse gemäß einer Ausführungsform der Erfindung mit der schematischen Darstellung der Aufeinanderfolge der Montage der Gehäuseeinzelteile;
- Fig. 3: das geschlossene Gehäuse, aufgesetzt auf ein Fußteil;
- Fig. 4: eine Teilansicht ähnlich der Fig. 2 zur Darstellung einer anderen Befestigungsart der Gehäusehaube;
- Fig. 5: eine weitere Ausführungsform des Computergehäuses und deren Zusammenbau;
- Fig. 6: in einer ähnlichen Darstellung wie Fig. 2 eine noch andere Ausführungsform des erfindungsgemäßen Computergehäuses, bei der ein Bodenteil und zwei Seitenteile einstückig sind;
- Fig. 7: eine Detaildarstellung der Ausführungsform gemäß Fig. 6;
- Fig. 8: eine Weiterbildung der Ausführungsform gemäß Fig. 5, in geschlossenem Zustand, mit eingebautem Computer mit eigenem Gehäuse; und
- Fig. 9, 10 und 11: verschiedene Möglichkeiten der Seitenwandbefestigung am Rahmenteil oder Fußteil.

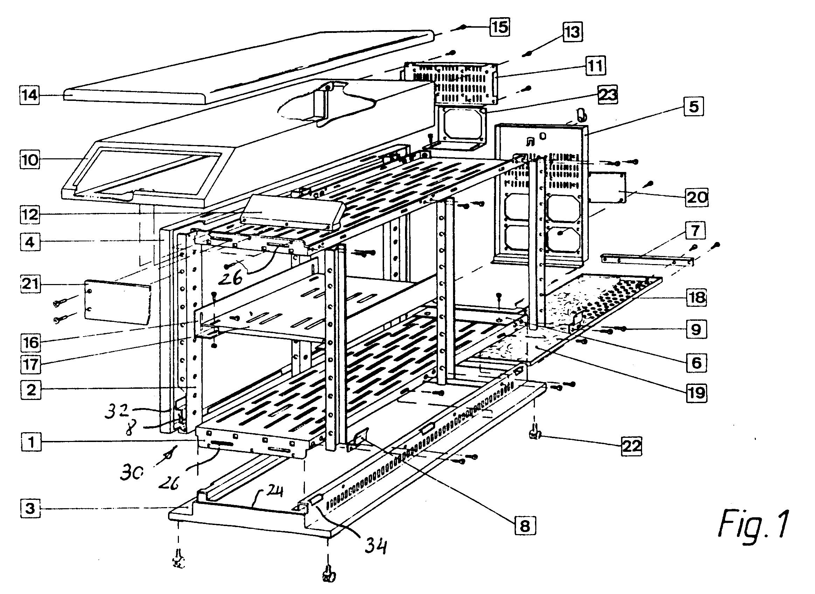

In Fig. 1 ist ein für den Einsatz der Erfindung vorgesehenes Computergehäuse dargestellt, bestehend aus einem Fußteil 3, das noch Laufräder 22 aufweisen kann, auf welchem Fußteil 3 ein Rahmenteil 30 befestigt werden kann, das zur Aufnahme von Einschüben, Baugruppenträgern Laufwerken, Netzteilen, Lüftern, einer Bedienungsfrontplatte 12 u. dgl. dienen kann, wobei das Rahmenteil 30 gemäß der Darstellung von Fig. 1 aus vertikalen Trägern 2 besteht, die ihrerseits durch eine untere und eine obere, jeweils identisch aufgebaute, jedoch umgekehrt montierte Platten 1 zusammengehalten werden, und zwar mit Hilfe von deutlich zu erkennenden Befestigungsschrauben.

Zwischen den Platten 1 ist mittels Montagewinkel 16 eine Montageplatte 17 angezogen, außerdem ist in den Fuß 3 ein Luftfiltereinsatz 18 mit einer Filtermatte 19 einschiebbar und der Einschubschlitz durch eine Abdeckplatte 7 verschließbar.

Das Computergehäuse weist weiterhin am Fußteil 3 bzw. am Rahmenteil 30 befestigbare Gehäusewandteile auf, wie Seitenblech 4, Rückwand 5 und Abdeckhaubenteil, der entweder flach sein kann, siehe Bezugszahl 14, oder erhöht sein kann, wie das Bezugszeichen 10 andeutet.

Im letzteren Falle wird eine zusätzliche Rückwand 11 benötigt. Die Befestigung erfolgt wiederum mit Befestigungsteilen 13, 15, oder durch Verschweißung an der Haube. Die dargestellte Rückwand 5 weist Durchbrüche zur Montage von Lüftungseinrichtungen auf, die, wenn Lüftungseinrichtungen nicht vorhanden sind, durch eine Blindplatte 20 geschlossen werden kann, die aber auch als Netz- oder Steckerfeldplatte ausgebildet sein kann. Der Lüfterwinkel 23 dient zu ähnlichen Zwecken für den Fall, daß die Haube 10 vorgesehen ist.

Bei Anordnung der Haube 10 kann eine Bedienungsfrontplatte 12 vorgesehen sein.

Auf die Vertikalstreben des Vorderendes kann eine Frontplatte 21 montiert werden, wiederum mit Hilfe von Befestigungseinrichtungen, beispielsweise Schrauben, die durch entsprechende in regelmäßigen Abständen angeordnete Durchbrüche in den Trägern oder Streben 2 angeordnet sind.

Wie aus Fig. 1, aber auch aus Fig. 9 zu erkennen ist, besitzt das Seitenblech 4, also eines der beiden Gehäusewandseitenteile, eine Befestigungseinrichtung in Form einer Lasche 32, die in eine entsprechend ausgerichtete Lasche 8 eines angrenzenden Teils, hier des Rahmenteils 30, eingeschoben ist. Die Laschen 32 bzw. 8 sind an der Gehäusewand 4 bzw. dem Träger 2 angeschweißt (mittels Punktschweißung) oder angenietet oder angeschraubt. Alternativ könnten auch Durchbrüche anstelle der unteren Lasche 8 vorgesehen sein, siehe beispielsweise die Durchbrüche 34 im Fußteil 3 (Fig. 1) oder im Rahmenteil 30 (Fig. 11). Auch kann der Seitenwandrand selbst in einen z. B. von einer Fußerstreckung 103 gebildeten Schlitz 27 aufgenommen werden, siehe Fig. 10.

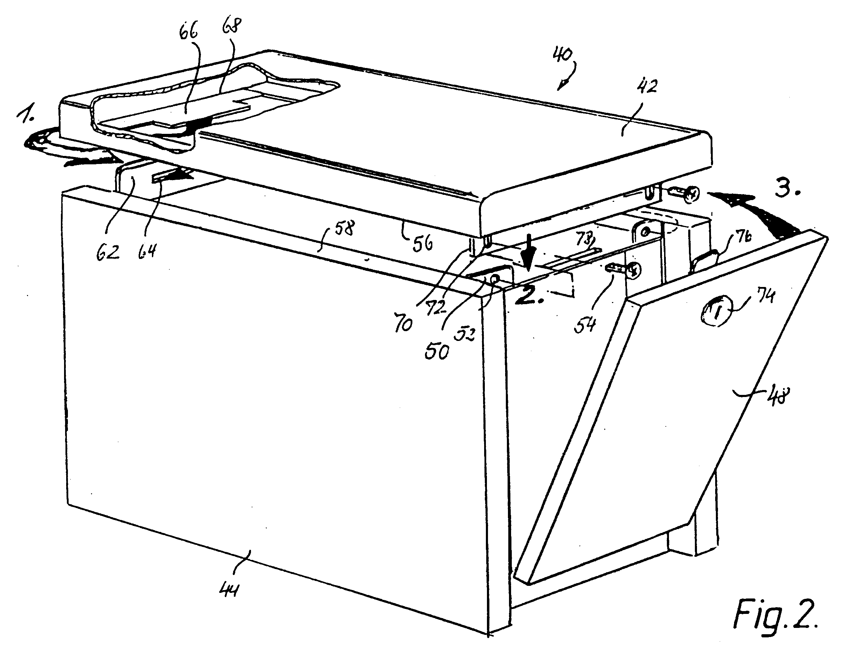

Es sei nunmehr auf Fig. 2 verwiesen, in der das Computergehäuse 40 in einer Darstellung zu erkennen ist, die die erfindungsgemäßen Aspekte besonders deutlich hervortreten lassen. Zu diesem Zweck sind Fußteil 3 (das erfindungsgemäß durch ein Bodenblech ersetzt sein kann) und Rahmenteil 30 sowie die anderen Einzelheiten der Fig. 1 weggelassen, zu erkennen sind jedoch in abgewandelter Ausführung ein Abdeckhaubenteil 42, zwei Längsseitenwandteile 44, eine Hinterwand 48. Am Rahmenteil 30 kann eine Vorderwand 46 befestigt sein, die in Fig. 2 jedoch nicht dargestellt ist. Die beiden Seitenwände 44 sind in der bereits geschilderten Weise mit Hilfe von innen am unteren Ende nach unten hin offenen L-Laschen 32 befestigt, die in entsprechende nach oben offene Laschen 8 oder in Durchbrüche 34 des Rahmenteils 30 oder des Fußteils 3 eingehängt sind, während die Längsseitenwände 44 oder das Rahmenteil 30 am oberen Ende jeweils zumindest eine von der Wandebene nach innen vorspringende weitere Lasche 50 tragen, die einen Durchbruch 52 für eine stiftartige Befestigungseinrichtung 54, hier in Form einer Kreuzschlitzhaube, besitzt. Eine Befestigung am anderen Ende kann wiederum über eine Lasche in Form des Bauteils 32 erfolgen, oder aber es wird der untere Rand 56 des Haubenteils 42 so weit nach unten gezogen, daß er die obere Kante 58 der Seitenwand 44 sichernd übergreift.

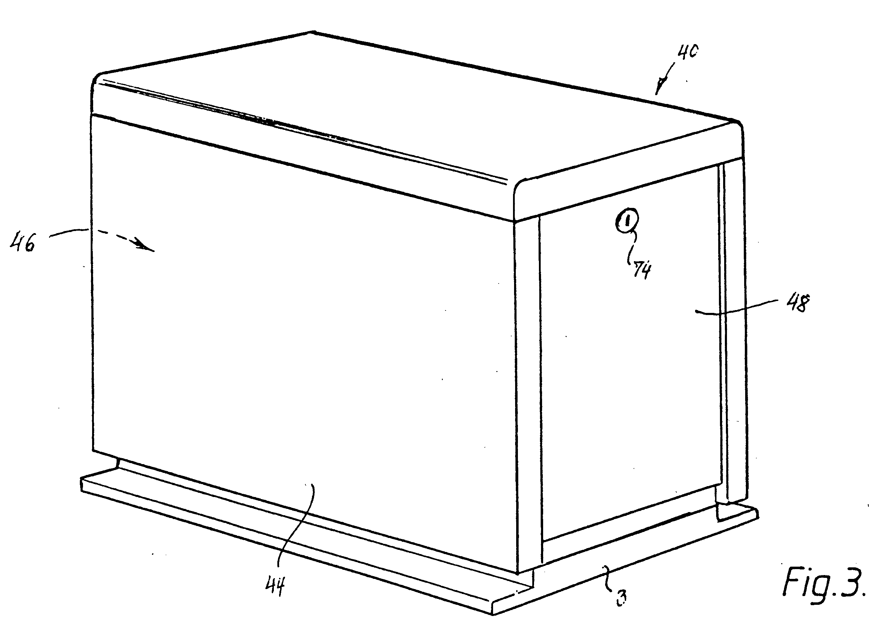

Die in Fig. 3 dargestellte Vorderwand 46 sowie die Hinterwand 48 besitzen am unteren Ende nach innen bzw. unten abgewinkelte Wandbereiche, wie beim Bauteil 5 in Fig. 1 unten erkennbar, die in entsprechende Durchbrüche einschiebbar oder hinter entsprechende Querleisten 24 am Fuß- oder Rahmenteil 3 bzw. 30, siehe beispielsweise auch den Schlitz 26 einhängbar sind, während die Vorderwand 46 oder das Rahmenteil 30 am oberen Ende in einen in den Bereich der Abdeckhaube 42 hineinragenden Wandbereich 62 ausläuft, der einen Querschlitz 64 zur Aufnahme einer Lasche 66 oder Abwinkelung aufweist, die am zugehörigen unteren Randende 68 der Haube 42 angebracht ist, oder durch Abwinkelung des Randendes entstanden ist.

Am gegenüberliegenden Ende besitzt die Haube eine nach unten vorspringende Lasche 70, die auch die Form wiederum einer Abwinkelung aufweisen kann, welche mit Durchbrüchen 72 wieder für ein stiftartiges Befestigungsmittel 54 versehen sind, vorzugsweise handelt es sich dabei wiederum um die bereits erwähnte Kreuzschlitzschraube 54, die auch durch die Bohrung 52 der Lasche 50 hindurchgreift.

Wie ohne weiteres verständlich sein wird, werden zur Montage des erfindungsgemäßen Computergehäuses zunächst die Seitenwände 44 in ihrem unteren Bereich eingehängt und dann gegen den Rahmen in die Stellung gedrückt, anschließend oder vorher wird dann in entsprechender Weise die Vorderwand 46 eingehängt und wiederum gegen den Rahmen gedrückt und dadurch in die vertikale Stellung gebracht, sofern diese Vorderwand nicht bereits mit dem Rahmenteil 30 verbunden ist oder mit diesem einstückig ist, woraufhin dann die Abdeckhaube 42 mit ihrer Lasche oder Vorsprung 66 in den Querschlitz 64 der Vorderwand 46 oder Rahmenteil 30 eingeschoben wird, wobei das andere Ende der Haube 42 noch schräg nach oben weist, wonach als nächster Montageschritt die Abdeckhaube 42 in die horizontale Lage gedrückt wird, wodurch sich die Lasche 70 der Haube 42 vor die Laschen 50 der beiden Seitenwände 44 oder des Rahmenteils 30 legt, derart, daß die Durchbrüche 72 und 52 zueinander ausgerichtet sind, so daß nunmehr die Schrauben 54 in ein in der Bohrung 52 gebildetes Schraubgewinde eingedreht werden können. Die beiden Seitenwände 44 wie auch die Haube 42 sind dadurch zueinander gesichert, ohne daß dazu der innere Rahmen unbedingt benötigt werden würde. Die Sicherung der Seitenwände 44 erfolgt durch die Laschen 50, falls diese an den Seitenwänden 44 befestigt sind, ansonsten durch ein Übergreifen der Haubenränder 56 über die oberen Randbereiche der Seitenwände.

Es ist zu erkennen, daß - bis auf die zuletzt erwähnten beiden Schrauben 54 - alle bisherigen Befestigungspunkte entweder abgedeckt sind, oder so gegeneinander blockiert sind, daß eine Öffnung nicht möglich ist. Um auch die Schrauben 54 abzudecken, läßt sich die Rückwand 48, die ebenfalls an ihrem unteren Ende in der bereits geschilderten Weise eingehängt sein kann, gegen die Lasche 70 drücken, wodurch die Schraubbefestigungen 54 abgedeckt werden. Um die Rückwand 48 in dieser senkrechten Stellung ebenfalls zu verriegeln, ist ein Vorreiberverschluß 74 vorgesehen, der mit seiner Zunge 76 entweder hinter ein Teil der Haube 42 zur Anlage gelangen kann oder aber in einem Schlitz 78, der im Rahmenteil 30 oder in einem Blechteil angebracht sein, welches Teil des Rahmens sein kann.

Ist der Vorreiberverschluß 74 mit einem Schloß versehen, wie meist üblich, läßt sich somit das Computergehäuse 40 nur noch von solchen Personen öffnen, die einen entsprechenden Schlüssel für den Vorreiberverschluß 74 besitzen. Alle anderen Befestigungspunkte sind dagegen nunmehr unzugänglich oder bei zusammengesetzten Gehäuseteilen nicht demontierbar, so daß der gewünschte Sicherungszweck erreicht wird.

Das Computergehäuse 40 ist in seiner verschlossenen Form, siehe auch Fig. 3, die den Fuß zusätzlich zeigt, durch die Verdeckung der verschiedenen Befestigungseinrichtungen auch ästhetisch ansprechend und außerdem leichter zu reinigen.

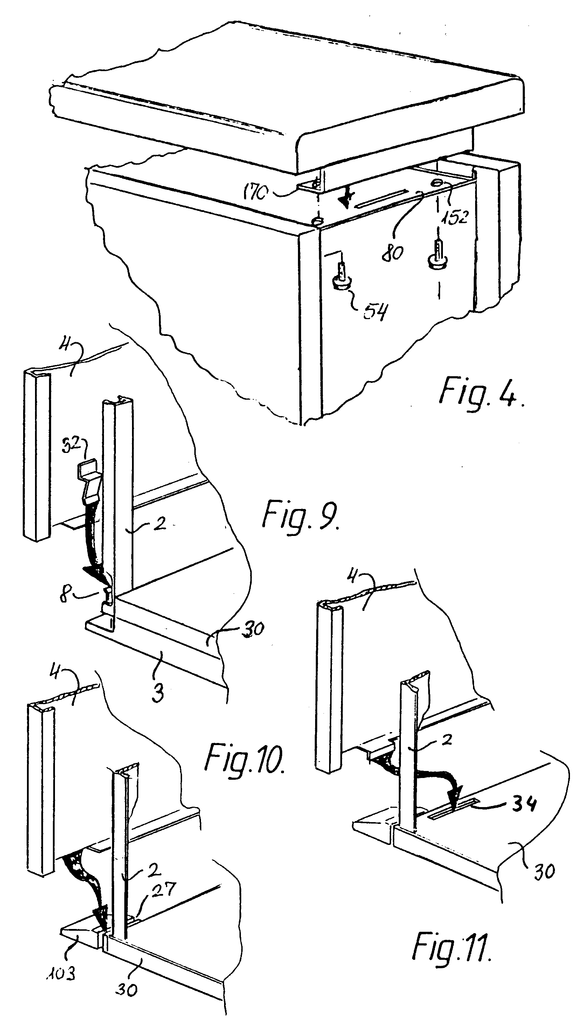

Gemäß Fig. 1 kann das Rahmenteil 30 eine obere, in Fig. 4 mit 80 bezeichnete Platte umfassen. Von dieser Platte können die Laschen 50 gemäß Fig. 2 vorspringen, um die Lasche 70 der Haube 42 zu befestigen. Bildet man diese Lasche der Haube 42 als Winkel 170 gemäß Fig. 4 aus, kann auf die Laschen 50 verzichtet werden, und die Befestigung mittels durch Bohrungen 152 in der Platte 80 geführte Schrauben 54 erfolgen.

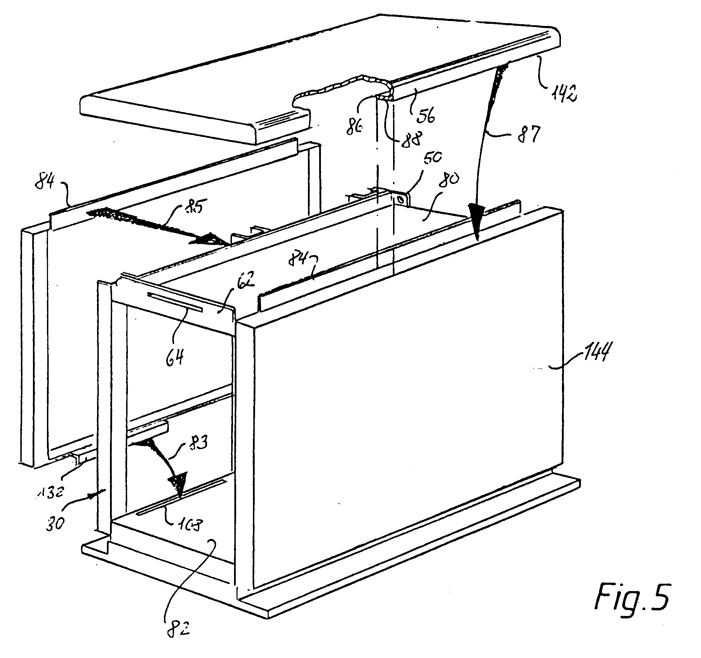

In Fig. 5 sind die Seitenwände 144 mit unteren Laschen 132 ausgestattet, die in Schlitze 108 einer Bodenplatte 82 einsteckbar sind, siehe Pfeil 83. Das obere Ende der Seitenwände 144 weist einen nach oben gerichteten Ansatz 84 auf, der nach Anlegen der Seitenwand 144 an das Rahmenteil 30, siehe Pfeil 85 bezüglich der Außenwandebene des Gehäuses zurückspringt und dadurch ein Überstülpen der Haube 142, siehe Pfeil 87, derart ermöglicht, daß einerseits die Haubenränder nicht über die Außenwandebene vorspringen, andererseits sich aber der Ansatz 84 hinter den Haubenrand 56, insbesondere deren Stirnkante 86 einer Randumbördelung 88, wie sie in Fig. 5 zu erkennen ist, legt und dadurch gesichert wird.

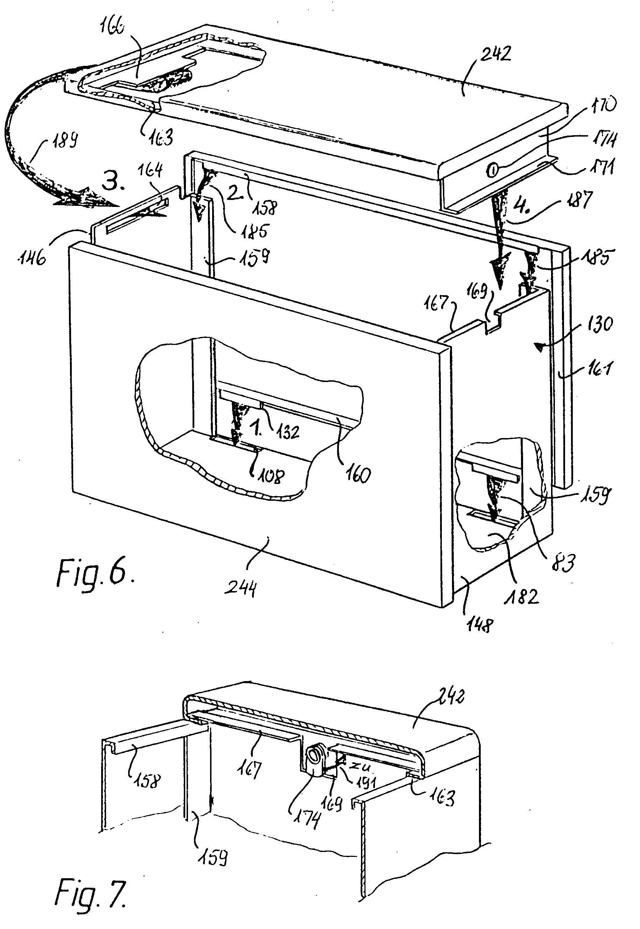

In Fig. 6 ist in einer ähnlichen Darstellung wie Fig. 2 eine noch andere Ausführungsform des erfindungsgemäßen Computergehäuses zu erkennen, bei der ein Bodenteil 182 und zwei sich gegenüberliegende Seitenwände, nämlich eine Vorderwand 146 und eine Rückwand 148 einstückig aus einem Blechstück gebogen oder durch Nietung oder Verschweißung miteinander verbunden sind und ein Rahmenteil 130 bilden, in das in der bereits beschriebenen Weise zwei Seitenwände 244 eingehängt werden können, beispielsweise ähnlich wie in Fig. 5 durch Anordnung von Schlitzen 108 in dem Bodenteil 182, in die entsprechende, von den Seitenwänden 244 ausgehende Laschen eingeschoben werden können, wodurch zunächst die Seitenwände 244 an ihren unteren Enden gehalten werden, siehe Pfeil 83, wonach (oder während gleichzeitig) eine U-förmige Abkantung über eine rechtwinklige Abkantung 159 von Vorderwand 146 bzw. Rückenteil oder Rückwand 148 gehängt werden kann, wie der Pfeil 185 andeutet. Die Abknickungen 159 und 158 dienen gleichzeitig zu Versteifungszwecken für die jeweiligen Wandbereiche. Ähnliches gilt für eine rechtwinklige Abkantung 160 am unteren Ende der Seitenwandplatten 244, von der aus die Laschen 132 ausgehen, wie Fig. 6 erkennen läßt. Entsprechend sind auch die Seitenkanten der Wandplatten 244 durch hier U-förmige Abkantungen 161 versteift.

Nach Einhängen der beiden Seitenwände 244 kann nunmehr ein Haubenteil 242, dessen Ränder ebenfalls Versteifungsabkantungen 163 aufweisen, mit einer von dieser Abkantung ausgehenden horizontalen Lasche 166 in einen Querschlitz 164 eingeschoben werden, siehe den Pfeil 189. Das den Schlitz - 164 tragende Ende der Teil des Rahmenteils 130 bildenden Wand 146, die hier Vorderwand ist, aber auch Rückwand sein kann, ist hier ohne Abkantung dargestellt. Eine Abkantung kann jedoch vorgesehen sein, beispielsweise in Form einer Abkantung, die gleichzeitig beim Herausstanzen des Schlitzes 164 entstanden sein kann, nicht dargestellt. Die Abkantung wäre dann das aus dem Schlitz herausgestanzte und weggebogene Material.

Das gegenüberliegende Teil 148 (hier Rückwand, kann aber auch Vorderwand sein) ist am oberen Ende wiederum mit einer Abkantung versehen, die nach innen gerichtet ist und die Bezugszahl 167 trägt. Außerdem ist ein Einschnitt 169 zu erkennen, in den ein Verriegelungselement, beispielsweise in Form eines Vorreiberverschlusses 174 zu liegen kommt, wenn die Abdeckhaube 242 nach Einstecken in den Schlitz 164 nach unten in Richtung des Pfeiles 187 geklappt wird. Der Vorreiberverschluß 174 ist dabei an eine Lasche 170 wiederum mit versteifender Abwinklung 171 eingebaut, beispielsweise eingeschraubt. Insbesondere kann es sich dabei um einen Vorreiberverschluß handeln, wie er auch bei Schaltschränken eingesetzt wird, wobei diese Vorreiberverschlüsse einen in ihrem Axialbereich angeordneten Schließzylinder tragen können. Die eigentliche Verriegelung kann auf verschiedene Weise erfolgen, beispielsweise durch Eindringen eines Hakens in eine Öse (nicht dargestellt), oder durch eine Vorreiberzunge, die sich hinter die Abkantung 167 legt, siehe Pfeil 191 in Fig. 7.

Die in den Fig. 6 und 7 dargestellte Ausführungsform ist noch einfacher in der Herstellung und in der Montage als die vorhergehend beschriebenen Ausführungsformen, und sie ist besonders geeignet für solche Computer, die bereits von einem Gehäuse umschlossen sind, welches aber noch ungesichert ist, so daß das erfindungsgemäße Computergehäuse im wesentlichen dazu dient, den unbefugten Zugang, der bei dem normalen Computergehäuse noch möglich wäre, zu erschweren oder unmöglich zu machen, ggf. auch einen zusätzlichen Schutz gegen äußere Einflüsse, wie insbesondere Spritz- und Schwallwasser zu ergeben. So haben herkömmliche Computer meist keine besonderen Vorkehrungen, um das Eindringen von Flüssigkeit zu verhindern, die beispielsweise von einer auf dem Computergehäuse abgestellten und umfallenden Kaffeetasse oder Coca-Cola-Dose stammen könnte. Derartige Unglücksfälle können in Bürobetrieben durchaus auftreten.

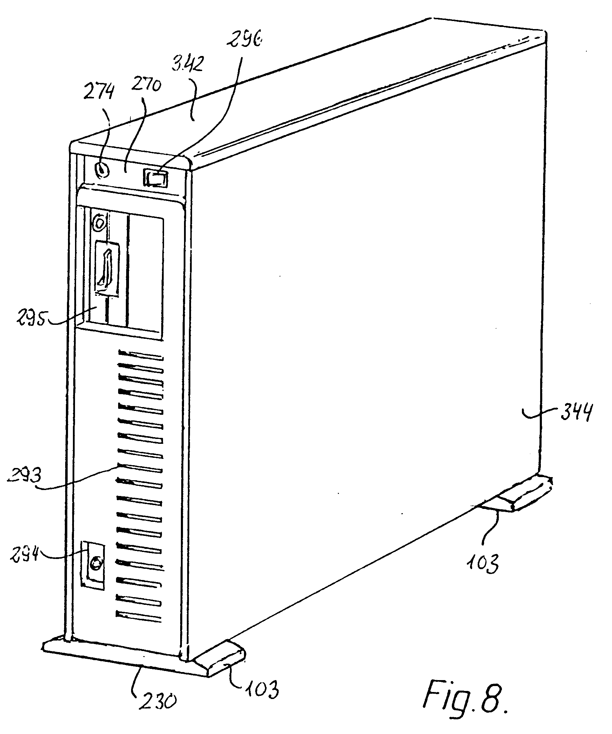

In Fig. 8 ist eine etwas abgewandelte Ausführungsform des Computergehäuses gemäß den Fig. 6 und 7 zu erkennen, wobei der Unterschied im wesentlichen darin besteht, daß besondere Fußanordnungen 103 an dem Rahmenteil 230 vorgesehen sind und die Vorderwand 246 von dem Gehäuse des eingebauten Computers gebildet wird, das z. B. Lüftungsschlitze 293 sowie Durchbrüche 294, 295 für irgendwelche Bedienungselemente wie Drucktasten, Schalter, Steckkontakte u. dgl. aufweisen kann. Die Abdeckhaube 342 besitzt wiederum eine Abkantung 270, die einen Verschluß 274 trägt, beispielsweise in Form wiederum eines einfachen Vorreiberverschlusses mit Zylinderschloßeinsatz, der entsprechend in irgendeinen vorspringenden Teil der Haube 342 zum Zwecke von deren Verriegelung eingreift. Es kann auch ein zusätzlicher Schalter 296 als Haupt- oder Netzschalter in diesem Bereiche angeordnet werden, siehe Fig. 8.

Der Computer ist - verdeckt durch die Seitenwände - mit dem Rahmenteil 230 verschraubt, kann also ohne vorherige Abnahme von Haube 342 und Seitenwänden 344 nicht aus dem Rahmenteil 230 herausgezogen werden, trotz fehlender Vorderwand beim erfindungsgemäßen Gehäuse dieser besonderen Ausführungsform.

## Patentansprüche

1. Computergehäuse, bestehend aus einem Rahmenteil (30) zur Aufnahme von Einschüben, Baugruppenträgern, Laufwerken, Netzteilen, Lüftern, Bedienungsfrontplatten und dgl. und/oder bereits in einem Gehäuse befindlichen Computern und am Rahmenteil (30) befestigbaren Gehäusewandteilen (44, 46, 48; 144) sowie einem Abdeckhaubenteil (42; 142), dadurch gekennzeichnet, daß die Gehäusewandteile (44, 46, 48; 144) und das Abdeckhaubenteil (42; 142) ihre eigenen Befestigungseinrichtungen (32, 50, 62, 70; 132, 170) und/oder die Befestigungseinrichtungen (8, 64, 70, 72) angrenzender, vorher befestigter Wand- oder Haubenteile derart abdecken, daß nur das letzte in der Montageaufeinanderfolge montierte Teil (48) mittels einer zugänglichen Befestigungseinrichtung (74, 76), die eine gegen unbefugtes Lösen sicherbare Verriegelung oder Verplombung umfaßt, arretierbar ist.

2. Computergehäuse nach Anspruch 1, dadurch gekennzeichnet, daß dem Computergehäuse ein Fußteil (3) zugeordnet ist, auf dem das Rahmenteil (30) befestigt ist.

3. Computergehäuse nach Anspruch 2, dadurch gekennzeichnet, daß die Gehäusewandteile (44, 46, 48) ggf. auch am Fußteil (3) befestigt sind.

4. Computergehäuse nach einem der Ansprüche 1 bis 3, dadurch gekennzeichnet, daß die Befestigungseinrichtung von den Wand- bzw. Haubenteilen (44, 46, 48 bzw. 42; 142) vorspringende Laschen (50, 62, 66, 70; 170, 32; 88) umfassen, die in Durchbrüchen (z. B. 64; 26) entsprechend ausgerichteter Laschen (8) eines angrenzenden Teils einschiebbar sind, oder einen Durchbruch (72) aufweisen, der zu einem Durchbruch (52; 152) des angrenzenden Teils (44) und/oder des Fuß- oder Rahmenteils derart fluchtet, daß ein beide Durchbrüche (72, 52; 152) durchgreifendeS Befestigungsmittel (54), wie Schraube, Stift, weitere Lasche, Zunge eines Verschlusses oder dgl. die Teile zueinander sichert.

5. Computergehäuse nach einem der Ansprüche 1 bis 4, dadurch gekennzeichnet, daß die sicherbare Verriegelung einen abschließbaren Vorreiberverschluß (74, 76) umfaßt.

6. Computergehäuse nach einem der Ansprüche 1 bis 4, dadurch gekennzeichnet, daß die sicherbare Verriegelung eine Spezialschraube oder eine Plombierung umfaßt.

7. Computergehäuse nach einem der Ansprüche 1 bis 6, dadurch gekennzeichnet, daß die Längsseitenwände (44) innen am unteren Ende nach unten offene L-Laschen (32) tragen, die in entsprechende nach oben offene L-Laschen (8) oder Durchbrüche (26) des Rahmen- oder Fußteils (30, 3) von oben einschiebbar sind, und daß die Längsseitenwände (44) oder der Rahmen (30) am oberen Ende zumindest eine von der Wandebene nach innen vorspringende weitere Lasche (50) tragen, die einen Durchbruch (52) für ein stiftartiges Befestigungsmittel (54) besitzt.

8. Computergehäuse nach Anspruch 7, dadurch gekennzeichnet, daß das stiftartige Befestigungsmittel (54) eine Blechschraube, eine Gewindeschraube, ein Spreizniet oder dgl. ist.

9. Computergehäuse nach Anspruch 7 oder 8, dadurch gekennzeichnet, daß die Vorder- und/oder Hinterwand am unteren Ende nach innen bzw. unten abgewinkelte Wandbereiche besitzen, die in entsprechende Durchbrüche (26) einschiebbar oder hinter entsprechende Querleisten am Fuß- oder Rahmenteil (3, 30) einhängbar sind, und daß die Vorderwand (46) am oberen Ende in einem in den Bereich der Haube (42) hineinragenden Wandbereich (62) ausläuft, der einen Querschlitz (64) zur Aufnahme einer horizontalen Lasche (66) oder Abwinkelung aufweist, die am zugehörigen unteren Randende (68) der Haube (42) angebracht ist, oder durch Abwinkelung des Randendes entstanden ist.

10. Computergehäuse nach Anspruch 9, dadurch gekennzeichnet, daß die Haube (42) am gegenüberliegenden Ende nach unten vorspringende Laschen (70) oder Abwinkelung (170) aufweist, die mit Durchbrüchen (72) für ein stiftartiges Befestigungsmittel (54) versehen sind.

11. Computergehäuse nach Anspruch 10, dadurch gekennzeichnet, daß die Durchbrüche (72) für das stiftartige Befestigungsmittel (54) zu den entsprechenden Durchbrüchen (52; 152) der Seitenwände (44) bzw. Rahmenteil (30) fluchten, und gemeinsam von dem stiftartigen Befestigungsmittel (54) durchdrungen sind.

12. Computergehäuse nach Anspruch 9, 10 oder 11, dadurch gekennzeichnet, daß die Hinterwand (48) oder die Vorderwand bzw. Rahmenteil (30) an ihrem oberen Ende einen abschließbaren Vorreiberverschluß (74, 76) aufweist, dessen Zunge (76) in einen Schlitz (78) oder hinter eine Strebe oder Abwinkelung der Haube (42) greift.

13. Computergehäuse nach einem der Ansprüche 1 bis 12, dadurch gekennzeichnet, daß die Seitenwände (144) am oberen Ende einen Ansatz (84) aufweisen, an den sich der nach unten gezogene Rand (56) der Haube (142) zur Sicherung der Seitenwand (144) anlegt.

14. Computergehäuse nach Anspruch 13, dadurch gekennzeichnet, daß der Ansatz (84) gegenüber der Außenwandebene der Seitenwand (144) zurückspringt.

15. Computergehäuse nach Anspruch 14, dadurch gekennzeichnet, daß der Rand (56) der Haube (142) eine nach innen weisende Umbördelung aufweist, bzw. ein U-Profil (88) bildet, dessen freie Stirnkante (86) die Anlage für den Ansatz (84) der Seitenwand (144) darstellt.

16. Computergehäuse nach Anspruch 1, dadurch gekennzeichnet, daß zwei, insbesondere sich gegenüberliegende Gehäusewandteile (146, 148) die mit einem Bodenteil (182) fest verbunden sind, z. B. verschraubt, vernietet, verschweißt, verklebt oder einstückig gebogen, und das Rahmenteil (130) bilden.

17. Computergehäuse nach einem der Ansprüche 1 bis 6, dadurch gekennzeichnet, daß die sicherbare Verriegelungseinrichtung (174) im Rahmenteil (130) angeordnet ist.

18. Computergehäuse nach einem der Ansprüche 1 bis 6, dadurch gekennzeichnet, daß die sicherbare Verriegelungseinrichtung (174) in einem am Rahmenteil (130) befestigbaren Gehäusewandteil (244) oder im Abdeckhaubenteil (242) angeordnet ist.

## Claims

1. Computer casing, comprising a frame piece (30) for receiving slide-in units, sub-assembly carriers, drive assemblies, power units, ventilators, an operating front panel and the like and/or computers already located in a casing, and casing wall pieces (44, 46, 48; 144) fixable to the frame piece (30) and a cover piece (42; 142), characterised in that the casing wall pieces (44, 46, 48; 144) and the cover piece (42, 142) conceal their own fixing devices (32, 50, 62, 70; 132, 170) and/or the fixing devices (8, 64, 70, 72) of adjoining, previously fixed wall or cover pieces in such a way that only the last part mounted in the mounting sequence can be secured by means of an accessible fixing device (74, 76) comprising a lock or seal securable against unauthorised detachment.

2. Computer casing according to Claim 1, characterised in that the computer casing has a foot piece (3) allocated to it to which the frame piece (30) is fixed.

3. Computer casing according to Claim 2, characterised in that the casing wall parts (44, 46, 48) are, if need be, also fixed to the foot piece (3).

4. Computer casing according to one of Claims 1 to 3, characterised in that the the fixing devices of the wall and cover pieces (44, 46, 48 and 42, 142) comprise projecting lugs (50, 62, 66, 70; 170, 32, 88) which can be inserted into apertures (for example 64; 26) of correspondingly aligned lugs (8) of an adjoining part or have an aperture (72) which is aligned with an aperture (52; 152) of the adjoining part (44) and/or the foot or frame piece in such a way that a fixing means (54) passing through both apertures (72, 52; 152), such as a screw, pin, further lug, tongue of a fastener or the like secures the parts to one another.

5. Computer casing according to one of Claims 1 to 4, characterised in that the securable lock includes a lockable catch fastener (74, 76).

6. Computer casing according to one of Claims 1 to 4, characterised in that the securable lock comprises a special screw or a seal.

7. Computer casing according to one of Claims 1 to 6, characterised in that the longitudinal side walls (44) have, at the inside on the lower end, L-lugs (32) open towards the bottom which can be inserted from above into corresponding L-lugs (8) or apertures (26) of the frame or foot piece (30, 3) which are open at the top, and in that the longitudinal side walls (44) or the frame piece (30) have, at the upper end, at least one further lug (50) projecting inwardly from the wall plane, said lug having an aperture (52) for a pin-like fixing means (54).

8. Computer casing according to Claim 7, characterised in that the pin-like fixing means (54) is a sheet metal screw, a threaded screw, an expanding rivet or the like.

9. Computer casing according to Claim 7 or 8, characterised in that the front and/or rear wall have inwardly/downwardly flexed wall areas at their lower end, which flexed wall areas can be inserted into corresponding apertures (26) or be positioned behind corresponding cross-pieces on the foot or frame piece (3, 30), and that the front wall (6) ends, at the upper end, in a wall area (62) projecting into the area of the cover (42), said wall area having a transverse slot (64) for receiving a horizontal lug (66) or flexed section which is attached to the associated lower edge end (68) of the cover (42) or has resulted from flexing of the edge end.

10. Computer casing according to Claim 9, characterised in that the cover (42) can have downwardly projecting lugs (70) or a flexed section (170) on the opposite end, said lugs or flexed section being provided with apertures (72) for a pin-like fixing means (54).

11. Computer casing according to Claim 10, characterised in that the apertures (72) for the pin-like fixing means (54) can align with the corresponding apertures (52; 152) of the side walls (44) or the frame piece (30) and be jointly passed through by the pin-like fixing means (54).

12. Computer casing according to Claim 9, 10 or 11, characterised in that the rear wall (48) or the front wall or frame piece (30) has a closable catch fastener (74, 76) at its upper end, the tongue of said catch fastener engaging in a slot (78) or behind a strut or flexed section of the cover (42).

13. Computer casing according to one of Claims 1 to 12, characterised in that the side walls (144) have a shoulder (84) on their upper end, against which shoulder the downwardly drawn edge (56) of the cover (142) bears in order to secure the side wall (144).

14. Computer casing according to Claim 13, characterised in that the shoulder (84) is offset with regard to the outer wall plane of the side wall (144).

15. Computer casing according to Claim 14, characterised in that the edge (56) of the cover (142) has an inwardly directed flange or forms a U-profile (88), the free front edge of (86) which constitutes the bearing surface for the shoulder (84) of the side wall (144).

16. Computer casing according to Claim 1, characterised in that two casing wall pieces (146, 148), in particular lying across from one another, are securely connected with a base piece (182), for example screwed, riveted, welded, stuck or bent in one piece and form the frame piece (130).

17. Computer casing according to one of Claims 1 to 6, characterised in that the securable locking device (174) is arranged in the frame piece (130).

18. Computer casing according to one of claims 1 to 6, characterised in that the securable locking device (174) is arranged in a casing wall piece (244) fixable on the frame piece (130) or in the cover piece (242).

## Revendications

1. Coffret d'ordinateur constitué par un cadre (30) destiné à recevoir des dispositifs insérables, des châssis équipés des mécanismes d'entraînement, des alimentations électriques, des organes d'aération, des plaques frontales de commande et analogues et/ou des ordinateurs déjà montés dans un boîtier, et par des parois (44,46,45,144) solidarisables au cadre (30) ainsi que par un capot de recouvrement (42,142), caractérisé en ce que les parois (44,46,48,144) et le capot de recouvrement (42,142) recouvrent leurs propres moyens de fixation (32,50,62,70,132,170) et/ou les moyens de fixation (8,64,70,72) de parois ou capots adjacents, montés au préalable, de telle sorte que seulement le dernier élément (48) dans la succession des opérations de montage est verrouillable à l'aide d'un moyen de fixation (74,76) accessible qui comporte un verrouillage ou plombage de sécurisation contre une désolidarisation non autorisée.

2. Coffret d'ordinateur selon la revendication 1 caractérisé en ce qu'un socle (3) y est associé, socle sur lequel est fixé le cadre (30).

3. Coffret d'ordinateur selon la revendication 2 caractérisé en ce que les parois (44,46,48) sont éventuellement aussi fixées au socle (3).

4. Coffret d'ordinateur selon l'une des revendications 1 à 3 caractérisé en ce que le moyen de fixation comporte des pattes (50,62,66,70,170,32,88) qui font saillie sur les parois (44,46,48) ou le capot de recouvremént (42,142) et qui sont engageables dans des ouvertures (par exemple 64,26) pratiquées dans des pattes (8) orientées de manière correspondante et solidaires d'un élément adjacent ou qui présentent une ouverture (72) qui se trouve dans l'alignement avec une ouverture (52,152) de l'élément adjacent (44) et/ou du socle ou du cadre de telle sorte qu'un moyen de fixation (54) traversant les deux ouvertures (72,52,152), tel qu'une vis, une broche, une autre patte, une languette de verrouillage ou analogue, assemble les deux éléments.

5. Coffret d'ordinateur selon l'une des revendications 1 à 4 caractérisé en ce que le verrouillage sécurisable comporte un moyen de fermeture à tourniquet obturable (74,76).

6. Coffret d'ordinateur selon l'une des revendications 1 à 4 caractérisé en ce que le verrouillage sécurisable comporte une vis spéciale ou un plombage.

7. Coffret d'ordinateur selon l'une des revendications 1 à 6 caractérisé en ce que les parois latérales longitudinales (44) sont munies, à l'extrémité inférieure, de pattes en forme de L (32) ouvertes vers le bas, qui sont engageables par le haut dans des pattes en forme de L ouvertes vers le haut (8) ou dans des ouvertures (26) pratiquées dans le cadre (30) ou le socle (3), et en ce que les parois latérales longitudinales (44) ou le cadre (30) sont équipés, à l'extrémité supérieure, d'au moins une patte supplémentaire (50) qui fait saillie vers l'intérieur sur le plan de la parois et qui est munie d'une ouverture (52) pour un moyen de fixation en forme de broche (54).

8. Coffret d'ordinateur selon la revendication 7 caractérisé en ce que le moyen de fixation (54) consiste en une vis Parker, une vis taraudeuse , un rivet à expansion ou analogue.

9. Coffret d'ordinateur selon la revendication 7 ou 8 caractérisé en ce que les parois frontales et/ou arrières comportent à l'extrémité inférieure, des parties repliées vers l'intérieur ou vers le bas, qui sont engageables dans des ouvertures correspondantes (26) ou sont accrochables derrière des lattes transversales au socle (3) ou au cadre (30), et en ce que la paroi frontale (6) s'étend à l'extrémité supérieure, dans une zone de paroi (62) qui se prolonge dans la zone du capot de recouvrement (42), la zone de paroi (62) comportant une fente transversale (64) destinée à recevoir une patte horizontale (66) ou une partie repliée agencée au bord inférieur correspondant (68) du capot de recouvrement (42) ou obtenue par pliage du bord externe.

10. Coffret d'ordinateur selon la revendication 9 caractérisé en ce que le capot de recouvrement (42) présente, à l'extrémité opposée, des pattes (70) faisant saillie vers le bas ou des parties repliées (170), qui sont munies d'ouvertures (72) pour un moyen de fixation en forme de broche (54).

11. Coffret d'ordinateur selon la revendication 10 caractérisé en ce que les ouvertures (72) pour le moyen de fixation en forme de broche (54) sont dans l'alignement avec les ouvertures correspondantes (52,152) pratiquées dans les parois latérales ou le cadre (30) et sont traversées simultanément de moyens de fixation en forme de broche (54).

12. Coffret d'ordinateur selon la revendication 9,10 ou 11 caractérisé en ce que la paroi arrière (48) ou la paroi frontale ou le cadre (30) présente, à son extrémité supérieure, une fermeture à tourniquet obturable (74,76)) dont la languette (76) s'engage dans une fente (78) ou derrière un renfort ou une partie repliée du capot (42).

13. Coffret d'ordinateur selon l'une des revendications 1 à 12 caractérisé en ce que les parois latérales (144) présentent, à l'extrémité supérieure, un prolongement (84) sur lequel vient s'appuyer le bord s'étendant vers le bas (56) du capot (142) en vue de la fixation de la paroi latérale (144).

14. Coffret d'ordinateur selon la revendication 13 caractérisé en ce que le prolongement (84) est en retrait par rapport au plan de la paroi latérale (144).

15. Coffret d'ordinateur selon la revendication 14 caractérisé en ce que le bord (56) du capot (142) présente un bord rabattu orienté vers l'intérieur , ou forme par exemple un profilé en U (88) dont l'arête frontale libre (86) constitue l'appui pour le prolongement (84) de la paroi latérale (144).

16. Coffret d'ordinateur selon la revendication 1 caractérisé en ce que deux parois de coffret, notamment des parois opposées (146,148), sont rigidement reliées à un fond (182), par exemple par vissage, rivetage, soudage, collage ou pliage d'une seule pièce, et constituent le cadre (130).

17. Coffret d'ordinateur selon l'une des revendications 1 à 6 caractérisé en ce que le dispositif de verrouillage sécurisable (174) est agencé dans le cadre (130).

18. Coffret d'ordinateur selon l'une des revendications 1 à 6 caractérisé en ce que le dispositif de verrouillage sécurisable (174) est agencé dans une paroi de coffret (244) solidarisable au cadre (130) ou dans le capot de recouvrement (242).
